# EUROPEAN PATENT APPLICATION

(11) **EP 0 685 889 A2**
(43) Date of publication of application: **06.12.1995**
(21) Application number: 95303619.1
(22) Date of filing: 26.05.1995
(51) Int. Cl.: H01L 29/744, H01L 29/06

(54) **Reverse conducting GTO thyristor and manufacturing method for the same**

(30) Priority: 02.06.1994 JP 120859/94
(71) Applicant: FUJI ELECTRIC CO. LTD., Kawasaki 210 (JP)
(72) Inventor: Kakiki, Hideaki, c/o Fuji Electric Co. Ltd., Kawasaki 210 (JP)
(74) Representative: Topley, Paul

(57) **Abstract**

To prevent a reverse conducting GTO thyristor from oozing off carriers from a diode part (14) into a GTO thyristor part (13), and to prevent the GTO thyristor part from false firing, and the false firing withstand capability of the reverse conducting GTO thyristor is improved by setting the lifetime of an isolation region shorter (15) than those of the GTO thyristor part and the diode part.

Setting the lifetime of the isolation region which isolates the GTO thyristor part from the diode part is performed by gold or platinum diffusion, by electron beam irradiation, or by a combination of gold or platinum diffusion and electron beam irradiation.

## Description

The present invention relates to a reverse conducting GTO (Gate Turn Off) thyristor which integrates a GTO thyristor and a diode connected in inverse-parallel to the GTO thyristor on a common semiconductor base.

A reverse conducting GTO thyristor is formed with a GTO thyristor and a free-wheeling diode integrated on a common semiconductor base, and used in electric power conversion devices such as inverters, converters and choppers of high withstand voltage and large current.

The present and prior art thyristors, and their methods of manufacture, will be described below with reference to the accompanying drawings, in which:
Figure 1 is a schematic diagram showing the main portions of a reverse conducting GTO thyristor and illustrating the photo-processing masks for setting lifetimes used in the prior art; and
Figure 2 is a schematic diagram showing the main portions of a reverse conducting GTO thyristor and photo-processing masks for setting lifetimes in an embodiment of the present invention.

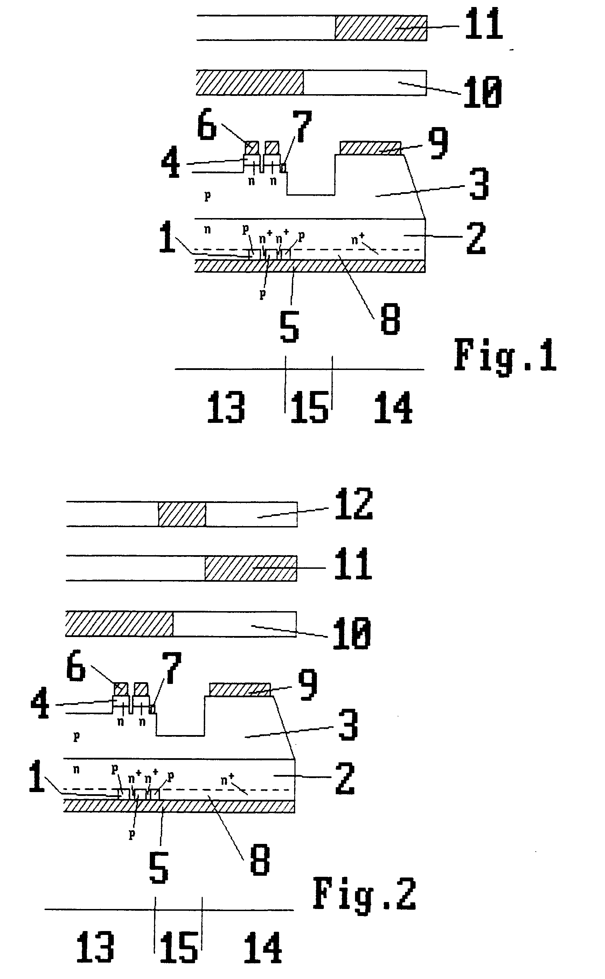

Referring now to the drawings, Figure 1 shows a sectional view of the main parts of the reverse conducting GTO thyristor, illustrating the positioning in relation thereto of conventionally used photo-processing masks 10 and 11 for setting lifetimes of a GTO thyristor part and diode part. Each hatched part in the photo-processing masks corresponds to a location in which a lifetime is set.

As is shown in Figure 1, the reverse conducting GTO thyristor has a GTO thyristor part 13 having a pnpn quadruple layer structure, and a diode part 14 having a pn double layer structure. The GTO thyristor part 13 and diode part 14 are integrated together on a common semiconductor base.

The GTO thyristor part 13 is composed of a (p) type emitter layer 1, an (n) type base layer 2, a (p) type base layer 3 and an (n) type emitter layer 4. A current flows from an anode 5 toward a cathode 6, and is interrupted by removing a gate current from a gate electrode 7 disposed on the (p) type base layer 3.

On the other hand, the diode part 14 is formed with the extended parts of the (n) type layer 2 and the (p) type layer 3, and is separated from the GTO thyristor part 13 by an isolation region 15, seen in Figure 1 as a trench. The (n) type base layer 2 is in contact with an extended part of the anode 5 through an (n+) type contact layer 8, and a diode anode 9 disposed on the (p) type layer 3 is connected to the cathode 6 of the GTO thyristor part through a metal contact plate (not illustrated) in contact with both the cathode 6 and the diode anode 9. As described above, the diode part 14 is connected in inverse-parallel to the GTO thyristor part. When forming the (n+) type layer 8 of the diode part 14, the (n+) type layer 8 is also formed on an entire area of the GTO thyristor part 13, and the (p) type emitter layer 1 is selectively formed within the (n+) type layer 8 at the appropriate location. A short-circuited structure in which the (n) type layer 2 is connected to the anode 5 is then formed. Further, the lifetimes of the GTO thyristor part 13 and the diode part 14 are set using the photo-processing masks 10 and 11 for setting lifetimes, and switching speeds of these parts are increased. Moreover, the trench formed in the isolation region 15 for isolating the GTO thyristor part 13 from the diode part 14, suppresses electrical interference between the GTO thyristor part 13 and the diode part 14.

When these reverse conducting GTO thyristors are operated in an inverter or the like, a current regenerative mode, the so-called free-wheeling mode, exists, and a current flows through the diode part connected in inverse-parallel to the GTO thyristor part in this mode. This regenerative current flowing through the diode part is cancelled by a turn-on current when a GTO thyristor part of another reverse conducting GTO thyristor is fired in an inverter circuit (not illustrated), and the diode part is reversely restored. However, while the regenerative current is flowing, carriers which transport a current ooze out through an isolation region into the GTO thyristor part. Therefore, when a turn-on current rise ratio (di/dt) is large, a positive voltage is applied to the GTO thyristor part while the carriers oozed out into the GTO thyristor part still remain. In this situation, the reverse conducting GTO thyristor is false fired. To counteract this, a large inductance (anode reactor) is placed in the inverter circuit for suppressing di/dt, and false firing is thus prevented.

A first object of the present invention is to provide a reverse conducting GTO thyristor having high false firing withstand capability by preventing the carriers from oozing off into the GTO thyristor part and thus protect the thyristor from false firing. A further object of the present invention is to provide its manufacturing method.

According to a first aspect, the object of the present invention is achieved by a reverse conducting GTO thyristor which comprises a GTO thyristor part having a pnpn quadruple layer structure, a diode part having a pn double layer structure integrated with the GTO thyristor part on a common semiconductor base; and an isolation region further comprising a trench which isolates the GTO thyristor part from the diode part, the isolation region having a lifetime shorter than those of the GTO thyristor part and the diode part.

It is preferable for the lifetime of the isolation part to be not longer than 10µs.

A second aspect of the present invention provides a method of manufacturing a reverse conducting GTO thyristor including a GTO thyristor part having a pnpn quadruple layer structure, a diode part having a pn double layer structure integrated with the GTO thyristor part on a common semiconductor base, and an isolation region further comprising a trench which isolates the GTO thyristor part from the diode part, the method including separately setting the lifetimes of the GTO thyristor part, the diode part and the isolation region.

The lifetime of the isolation region which isolates the GTO thyristor part from a the diode part is shortened by either diffusion of a heavy metal such as gold or platinum, or by irradiation using an electron beam, or by a combination of these two methods. This treatment prevents carriers from oozing off into the GTO thyristor part. The reverse conducting GTO thyristor is thus prevented from false firing, and improved an inverse firing withstand capability is achieved.

Figure 2 shows an embodiment of the present invention, and the constituents common with Figure 1 are designated by the same reference numerals. In Figure 2, a photo-processing mask 12 for setting the lifetime of an isolation region 15 is added to masks in Figure 1. A method of setting the lifetime is as follows. Though not illustrated, an oxide film is deposited onto the silicon surface of a GTO thyristor part 13, a diode part 14, and the isolation region 15. A window is opened in the oxide film on the isolation region 15 using the photo-processing mask 12 for setting a lifetime. Gold atoms are diffused through this window at a temperature of 850 to 900°C, and attached selectively on the silicon surface of the isolation region 15 . Next, a second window is opened in the oxide film on the diode part 14 using the photo-processing mask 11. Gold atoms are diffused at a temperature of 800 to 850°C through this window, and attached selectively on the silicon surface of the diode part 14. A third window is then opened in the oxide film on the GTO thyristor part 13 using the photo-processing mask 10. Gold atoms are diffused through this window with a temperature of 780 to 850°C, and attached selectively on the silicon surface of the GTO thyristor part 13. While the lifetime setting operation is described here using gold atoms, it is to be understood that platinum or other heavy metal atoms may be used at different diffusion temperatures. By this method, the lifetime of each part or region is set at for example 10 to 30µs in the diode part 14, 10 to 50µs in the GTO thyristor part 13, and 10µs or less in the isolation region 15. Therefore, the lifetime of the isolation region can be set shorter than those of the other parts.

In another method, the lifetime of the isolation region 15 is shortened relative to the lifetimes of the GTO thyristor part 14 and the diode part 14 by setting the lifetimes of the GTO thyristor part 14, the diode part 14, and the isolation region 15 by diffusing gold or platinum on all three areas at the same temperature as described above, and afterward irradiating the isolation region 15 only with an electron beam of 1 to 50 Mrad.

Alternatively, the isolation region 15 only may be irradiated with an electron beam, and annealed at a temperature of about 200°C. In this case, since the annealing temperature is low, the lifetimes of the GTO thyristor part 13 and the diode part 14 are not changed, and the lifetime of the isolation region 15 only can be set shorter as desired than the those of the GTO thyristor part 13 and the diode part 14 by appropriately setting the annealing temperature. The product yield can be improved by performing this process as the last manufacturing step, and thus setting the lifetime with high precision.

Using the techniques of the present invention, the lifetime of an isolation region between the GTO thyristor part and the diode part of a reverse conducting GTO thyristor is shortened in comparison to those of the other parts, and the false firing withstand capability of the GTO thyristor part is thus improved. The necessary inductance for suppressing di/dt can be reduced, and an inverter circuit using the thyristors can be made smaller and lighter.

## Claims

1. A reverse conducting GTO thyristor comprising:
a GTO thyristor part having a pnpn quadruple layer structure;
a diode part having a pn double layer structure integrated with the GTO thyristor part on a common semiconductor base; and
an isolation region comprising a trench which isolates the GTO thyristor part from the diode part, characterised in that the isolation region having a lifetime shorter than those of the GTO thyristor part and the diode part.

2. The reverse conducting GTO thyristor as claimed in claim 1, characterised in that the lifetime of the isolation region is not longer than 10µs.

3. A method of manufacturing a reverse conducting GTO thyristor including a GTO thyristor part having a pnpn quadruple layer structure, a diode part having a pn double layer structure integrated with the GTO thyristor part on a common semiconductor base, and an isolation region further comprising a trench which isolates the GTO thyristor part from the diode part, characterised in that the method including separately setting the lifetimes of the GTO thyristor part, the diode part and the isolation region.

4. A method according to claim 3, characterised in that the lifetimes of the GTO thyristor part, the diode part and the isolation region are set by forming an oxide film on the silicon surface of the GTO thyristor part 13, the diode part 14, and the isolation region 15;
opening a first window in the oxide film over the isolation region 15 using a photo-processing mask 12, diffusing heavy metal atoms through this window at a first temperature to attach them on the silicon surface of the isolation region 15;
opening a second window in the oxide film over the diode part 14 using a photo-processing mask 11, and diffusing heavy metal atoms at a second temperature through this second window to attach them on the silicon surface of the diode part 14; and
opening a third window in the oxide film over the GTO thyristor part 13 using a photo-processing mask 10, and diffusing heavy metal atoms through this window at a third temperature to attached them selectively on the silicon surface of the GTO thyristor part 13.

5. A method according to claim 3, characterised in that the lifetimes of the GTO thyristor part, the diode part and the isolation region are set by diffusing heavy metal atoms on all three areas at the same temperature, and afterward irradiating the isolation region 15 only with an electron beam of 1 to 50 Mrad.

6. A method according to claim 3, claim 4 or claim 5, characterised in that the heavy metal atoms are atoms of gold or platinum.

7. A method according to claim 3, characterised in that the lifetimes of the GTO thyristor part, the diode part and the isolation region are set by irradiating the isolation region 15 only with an electron beam, and subsequent annealing of the semiconductor at a temperature of about 200°C.
